(19) Europäisches Patentamt
European Patent Office
Office européen des brevets

(11) **EP 1 116 958 B1**

(12) **EUROPÄISCHE PATENTSCHRIFT**

(45) Veröffentlichungstag und Bekanntmachung des Hinweises auf die Patenterteilung:
**27.06.2012 Patentblatt 2012/26**

(51) Int Cl.:
***G01R 31/36*** *(2006.01)*

(21) Anmeldenummer: **00124029.0**

(22) Anmeldetag: **04.11.2000**

(54) **Verfahren zur Bewertung der Gebrauchstüchtigkeit einer Speicherbatterie bei elektrischer Belastung der Speicherbatterie**

Method of evaluating the quality of a storage battery during electrical discharge of the storage battery

Procédé d'évaluation de la qualité d'un accumulateur durant la décharge électrique de l'accumulateur

(84) Benannte Vertragsstaaten:
**AT BE CH CY DE DK ES FI FR GB GR IE IT LI LU MC NL PT SE TR**

(30) Priorität: **11.01.2000 DE 10000729**

(43) Veröffentlichungstag der Anmeldung:
**18.07.2001 Patentblatt 2001/29**

(73) Patentinhaber: **VB Autobatterie GmbH & Co. KGaA 30419 Hannover (DE)**

(72) Erfinder:
• **Meissner, Eberhard, Dr.**
**31515 Wunstorf (DE)**
• **Bräuninger, Sigmar, Dr.**
**88709 Meersburg (DE)**

(74) Vertreter: **Lins, Edgar et al**
**Gramm, Lins & Partner GbR**
**Theodor-Heuss-Strasse 1**
**38122 Braunschweig (DE)**

(56) Entgegenhaltungen:
**EP-A- 0 004 382 DE-C- 3 213 516**

• **PATENT ABSTRACTS OF JAPAN vol. 1999, no. 04, 30. April 1999 (1999-04-30) & JP 11 014719 A (SHINEI DENSHI KEISOKKI KK), 22. Januar 1999 (1999-01-22)**

**Beschreibung**

Die Erfindung betrifft ein Verfahren zur Bewertung der Gebrauchstüchtigkeit einer Speicherbatterie bei elektrischer Belastung der Speicherbatterie.

Für den Anwender von Batterien ist es von besonderer Bedeutung, den Ladezustand und die Hochstrombelastbarkeit der Batterien zu kennen. Beispielsweise sind für die Fähigkeit einer Starterbatterie, ein Kraftfahrzeug mit einem Verbrennungsmotor zu starten, der Ladezustand und der Alterungszustand, bzw. der sich abzeichnende Kapazitätsverfall der Batterie maßgeblich, da dadurch die der Starterbatterie entnehmbare Stromstärke bzw. deren Leistungsabgabe begrenzt wird. Von besonderer Bedeutung ist die Ermittlung des Ladezustandes bzw. der Startfähigkeit einer Batterie in den Fällen, in denen beispielsweise intermittierender Motorbetrieb vorliegt, da dann in den Motorstillstandzeiten das Bordnetz des Fahrzeuges mit seinen Verbrauchern weiter betrieben wird, allerdings der Generator keinen Strom erzeugt. Die Überwachung des Ladezustandes und der Startfähigkeit der Batterie muss in solchen Fällen gewährleisten, dass der Energieinhalt der Batterie stets ausreichend bleibt, um den Motor noch zu starten.

Zur Messung des Ladezustandes von Akkumulatoren sind die verschiedensten Verfahren bekannt. In vielen Fällen werden integrierende Messgeräte benutzt (Ah-Zähler), wobei der Ladestrom gegebenenfalls unter Bewertung mit einem festen Ladefaktor berücksichtigt wird. Da die nutzbare Kapazität einer Batterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE-PS 2242510 ist es beispielsweise bekannt, bei einem Verfahren zur Messung des Ladezustandes den Ladestrom mit einem von der Temperatur und vom Ladezustand der Batterie selbst abhängigen Faktor zu bewerten.

Der DE-OS 4007883 ist ein Verfahren zu entnehmen, bei dem die Startfähigkeit eines Akkumulators durch Messung von Akkumulatorspannung und Batterietemperatur und Vergleich mit einer für den zu prüfenden Batterietyp geltenden Ladezustandskurvenschar ermittelt wird.

Der DE-OS 19543874 ist ein Berechungsverfahren für die Entladecharakteristik und Restkapazitätsmessung einer Batterie zu entnehmen, bei welchem ebenfalls Strom, Spannung und Temperatur gemessen wird, wobei die Entladungscharakteristik durch eine mathematische Funktion mit gekrümmter Oberfläche angenähert wird.

In der JP 11 014719 ist ein Verfahren zur Untersuchung eines Lithium-Ionen-Akkumulators bekannt, bei dem die Klemmenspannung nach Entladung für eine festgelegte Zeit gemessen wird. Die Differenz eines Spannungswertes bei der Entladung einer ungenutzten Referenzbatterie für eine bestimmte Zeit und die Klemmenspannung der untersuchten Batterie nach Entladung für eine bestimmte Zeit wird bestimmt und die Lebensdauer des Akkumulators hieraus ermittelt.

In der EP 0 004 382 A1 ist ein Verfahren zum fortlaufenden Anzeigen der Qualität einer Batterie beschrieben, die mit regelmäßig wiederkehrenden kurzen Entladestromimpulsen belastet wird. Der sich bei einem Entladestromimpuls einstellende Batteriespannungswert wird gemessen und bis zum Auftreten des nächsten Entladestroms gespeichert, um die Differenz zwischen dem Batteriespannungswert und einem vorgegebenen Minimalspannungswert als Maß für die Qualität der Batterie anzuzeigen.

Die DE-PS 3901680 beschreibt ein Verfahren zur Überwachung der Kaltstartfähigkeit einer Starterbatterie, bei dem die Starterbatterie zeitweise mit einem Widerstand belastet wird, die Spannung die am Widerstand abfällt gemessen wird und daraus im Vergleich mit Erfahrungswerten festgestellt wird, ob die Kaltstartfähigkeit der Batterie noch ausreicht. Zur Belastung der Starterbatterie dient dabei der Anlassvorgang.

Schließlich ist der DE-OS 4339568 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird, wobei zusätzlich auch die Batterietemperatur berücksichtigt wird. Dabei werden die während verschiedener Zeiträume gemessenen Ladeströme miteinander verglichen und daraus eine Restkapazität ermittelt.

Allerdings reicht die Feststellung des Ladezustandes nicht immer aus, insbesondere da beispielsweise zu berücksichtigen ist, dass bei einer stark gealterten Batterie trotz hinreichenden Ladezustands bei Belastung die Spannung zusammenbricht und somit die Gebrauchsfähigkeit der Batterie nicht gewährleistet ist.

Aufgabe der Erfindung ist es, eine über die Feststellung des Ladezustands herausgehende Kenngröße der Batterie zu ermitteln, aus der sich auf die Gebrauchstüchtigkeit der Batterie schließen lässt.

Diese Aufgabe wird bei einem Verfahren der eingangs genannten Art durch die im kennzeichnenden Teil des Anspruchs 1 genannten Merkmale gelöst. In den Unteransprüchen sind vorteilhafte Ausgestaltungen dieses Verfahrens angegeben.

Ein beispielhaftes Verfahren ermittelt die Gebrauchstüchtigkeit SOH (state of health) einer elektrischen Speicherbatterie für eine speziellen Anwendungsfall als eine Funktion mit stetigem Wertebereich, wobei sich der ermittelte Wert durch Vergleich der Spannung der Speicherbatterie bei Belastung mit einem konkreten Belastungsprofil mit einem Grenzwert für diese Spannung sowie gegebenenfalls mit einem Sollwert (Neuwert) ergibt.

Eine abgestufte Quantifizierung der Gebrauchstüchtigkeit mit einem steigen Wertebereich eines Gebrauchstüchtigkeitswertes SOH geht über eine rein binäre Aussage

- die Leistungsfähigkeit reicht noch aus, um betriebsbestimmte Funktion zu erfüllen, oder
- die Leistungsfähigkeit reicht nicht mehr dazu aus

deutlich hinaus. Die ständige Bestimmung dieses stetigen Gebrauchstüchtigkeitswerts und die Beobachtung der zeitlichen Veränderung ihres Wertes ermöglichen weiterhin die Verwendung mathematischer Verfahren wie der Bildung von Mittelwerten, der zeitlichen Differenzierung, der Bestimmung von Wendepunkten, der Errechnung von Trends etc., was bei diskreten Aussagen zur Verfügbarkeit einer Speicherbatterie nicht möglich ist.

Das erfindungsgemäße Verfahren bewertet die Gebrauchstüchtigkeit einer elektrischen Speicherbatterie nicht pauschal, sondern konkret für einen speziellen Anwendungsfall. Denn eine Speicherbatterie kann für eine anspruchsvolle Anwendung mit hoher Leistungsanforderung oder mit Leistungsanforderungen unter ungünstigen Betriebsbedingungen (wie z.B. niedrigen Temperaturen oder niedrigem Ladezustand) bereits nicht mehr geeignet sein (d.h. das Ende ihrer Gebrauchsdauer ist erreicht), während sie für eine weniger anspruchsvolle Anwendungen noch durchaus geeignet ist. Diese differenzierte Betrachtung der Gebrauchstüchtigkeit stellt die jeweilige Funktion sicher und vermeidet gleichzeitig einen vorzeitigen und damit unnötigen Austausch der Speicherbatterie.

Eine typische Anwendung von Speicherbatterien ist die hypothetische Belastung mit einem elektrischen Strom I(t) oder einer elektrischen Leistung P(t), wobei die Belastung entweder in Lade- oder Entladerichtung wirken kann, oder sogar beide Stromrichtungen umfassen kann, und ihr Wert eine Funktion der Zeit ist. Dieses für den konkreten Anwendungsfall charakteristische Belastungsprofil I(t) bzw. P(t) wird erfindungsgemäß als Kriterium zur Quantifizierung der Verfügbarkeit verwendet.

Unter der Belastung I(t) bzw. P(t) ändert sich die Spannung der Speicherbatterie, und zwar zu höheren Werten bei Ladung und zu niedrigeren Werten bei Entladung. Die technisch zulässigen oder sinnvollen Spannungswerte sind jedoch begrenzt, und zwar nach oben durch die maximale Ladespannung des Akkumulators (die im Einzelfall u.a. von dessen Bauart, Temperatur und Ladezustand abhängt) sowie nach unten durch die Funktionsfähigkeit der Komponente (n), die von der Speicherbatterie mit elektrischer Leistung versorgt werden.

Im folgenden wird meist eine Belastung der Speicherbatterie in Entladerichtung betrachtet. Die Erfindung ist allerdings nicht darauf beschränkt, sondern umfasst selbstverständlich Belastungen in Laderichtung sowie Kombinationen von Lade- und Entladebelastungen.

Im Falle der Entladung gibt es eine untere Spannungsschwelle U1, die auch unter Last I(t) bzw. P(t) nicht unterschritten werden darf, um die Funktionssicherheit einer Komponente zu gewährleisten.

Gebrauchsfähig im Sinne der Erfindung ist also eine Speicherbatterie, deren berechnete , Spannung unter dieser Last zu jeder Zeit höher liegt als U1. Der kleinste sich unter dieser Last einstellende Spannungswert wird mit Umin bezeichnet.

Erreicht Umin gerade den Schwellwert U1, ohne ihn zu unterschreiten, so wird der Speicherbatterie der Gebrauchstüchtigkeitswert SOH = 0 zugeordnet.

Insbesondere eine neuwertige Batterie hat einen minimalen Spannungswert Umin = Umin* unter dieser Last, der größer ist als U1 : Umin* > U1. Andernfalls wäre diese Batterie selbst im Neuzustand ungeeignet für die konkrete Anwendung. Einer Speicherbatterie mit minimalen Spannungswert Umin* unter der Last wird der Gebrauchstüchtigkeitswert SOH = 1 (oder alternativ 100%) zugeordnet.

Für Speicherbatterien mit anderen minimalen Spannungswert Umin unter der definierten Last I(t) bzw. P(t) wird allgemein folgende Gebrauchstüchtigkeit zugeordnet:

$$
\begin{array}{ll}
U_{min} > U_{min}^* & SOH > 1 \\
U_{min} = U_{min}^* & SOH = 1 \\
U1 < U_{min} < U_{min}^* & 0 < SOH < 1 \\
U1 = U_{min} & SOH = 0 \\
U1 > U_{min} & SOH < 0
\end{array}
$$

wobei die Skalierung der Einfachheit halber linear nach folgendem Schema erfolgen kann, ohne dass dadurch andere, nichtlineare Skalierungen von der Erfindung ausgeschlossen würden:

$$
SOH = (U_{min} - U1) / (U_{min}^* - U1)
$$

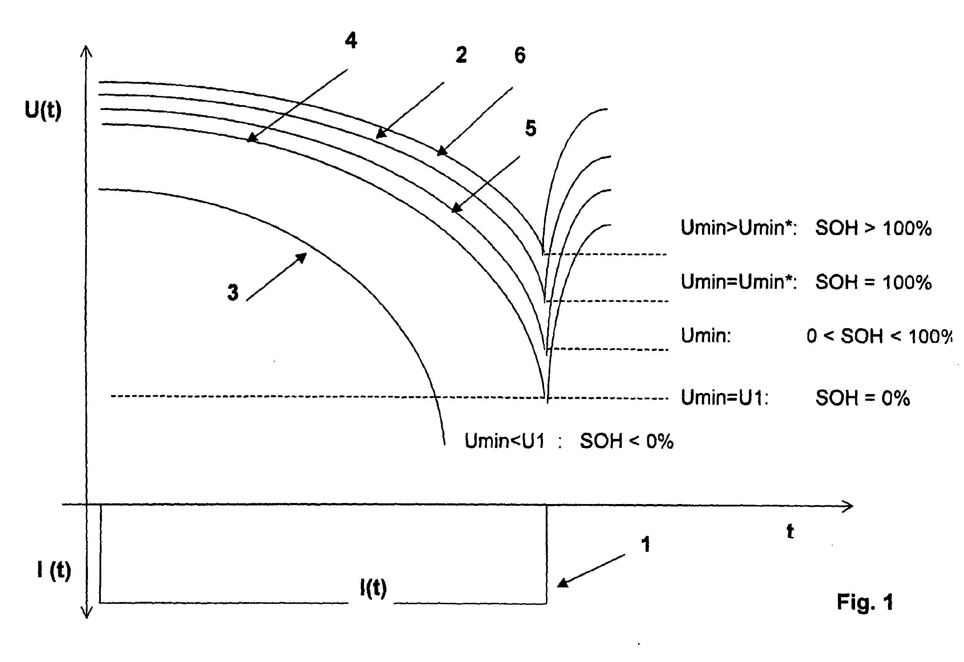

Diese Zusammenhänge sind schematisch in der Figur 1 dargestellt, in der Kurve 1 ein bestimmtes Stromprofil I(t), Kurve 2 das Verhalten einer neuwertigen Batterie, Kurve 3 das Verhalten einer nicht mehr gebrauchstüchtigen Batterie, Kurve 4 das Verhalten einer grenzwertigen Batterie und Kurve 5 das Verhalten einer noch nicht geschädigten aber nicht mehr neuwertigen Batterie darstellt. Kurve 6 stellt das Verhalten einer Batterie dar, das besser ist als das einer für diesen Zweck eigentlich bestimmten Batterie.

Die Spannungsschwelle U1 wird im allgemeinen ein für die konkrete Anwendung konstanter Wert sein. Die minimalen Spannungswerte Umin einer beliebigen und Umin* einer neuen Batterie unter der definierten Last I(t) bzw. P(t) hängen dagegen insbesondere von der Temperatur und vom Ladezustand der Batterie ab. Es ist deshalb Teil dieser Erfindung, diese Abhängigkeiten ebenfalls zu quantifizieren, und den Verfügbarkeitswert, der der Speicherbatterie zugewiesen wird, auf eine Nenn-Temperatur To und einen Nenn-Ladezustand SOCo zu beziehen, und gegebenenfalls Umrechnungen vom aktuellen Zustand (T, SOC) auf den Nenn-Zustand (To, SOCo) oder umgekehrt vorzunehmen.

Weiterhin ist es Teil der Erfindung, Zusammenhänge zwischen einerseits der sich unter dem Lastprofil I(t) bzw. P(t) einstellenden Spannung, insbesondere der minimalen Spannung Umin, und andererseits der Temperatur T sowie dem Ladezustand der Batterie SOC zu nutzen, um so Umin zu erhalten und damit einen Gebrauchstüchtigkeitswert SOH zu errechnen, der sich auf einen beliebigen Zustand (T, SOC) bezieht, ohne dass aktuell die Batterie mit dem Lastprofil I(t) bzw. P(t) elektrisch beaufschlagt wird. Dadurch ist es möglich, eine aktuelle Aussage zu SOH zu erhalten.

Insbesondere kann - ohne dass sich die Erfindung ausschließlich auf diese Vorgehensweise beschränkt - für die Spannungsantwort U(t) der Batterie auf die Strombelastung I(t) der lineare Ansatz

$$U(t) = Uo(SOC,T) + Ri(SOC,T) \times I(t)$$

verwendet werden.

Setzt man nun Umin = Minimum { U(t) } (Minimum { U(t) } steht für den kleinsten Spannungswert aus U(t), der sich durch Einsetzen von I(t) ergibt, so erhält man einen Wert für SOH.

Durch diese Vorgehensweise ist die Ermittlung der Gebrauchstüchtigkeit einer Speicherbatterie erfindungsgemäß zurückgeführt auf die Messung des Ladezustandes SOC, des dynamischen Innenwiderstandes Ri, und der Temperatur der betrachteten Speicherbatterie.

Es ist somit nicht erforderlich, die Batterie tatsächlich mit dem Lastprofil I(t) zu beaufschlagen, auf das sich die Angabe der Gebrauchstüchtigkeit der Batterie bezieht.

Es ist weiterhin nicht erforderlich, die Speicherbatterie in den Ladezustand zu versetzen oder auf die Temperatur zu bringen, auf die sich die Angabe der Gebrauchstüchtigkeit der Batterie bezieht.

Die vorstehenden Erläuterungen beziehen sich auf den Fall einer reinen Entladebelastung.

Im Fall einer reinen Ladebelastung wird analog vorgegangen, an die Stelle von Umin tritt Umax, und die Relationszeichen <" bzw. ,,>" werden passend vertauscht.

Besteht die Belastung aus Lade- und Entladebelastungen im Wechsel, so kann schrittweise für jeden Abschnitt einzeln vorgegangen werden. Die Gebrauchstüchtigkeit der Batterie für das gesamte Belastungsprofil ist dann der kleinste der für die einzelnen Abschnitte des Belastungsprofils erhaltenen einzelnen Gebrauchstüchtigkeits-Werte.

In einer Ausführungsform der Erfindung wird

a) ein Belastungsprofil in Form eines Stromprofils (I(t) oder eines Leistungsprofils P(t) als Funktion der Zeit t vorgegeben, mit welchem die Speicherbatterie hypothetisch beaufschlagt wird,
b) die Spannungsantwort U(t) der Speicherbatterie auf dieses Belastungsprofil rechnerisch ermittelt,
c) ein Spannungsgrenzwert U1 vorgegeben, der bei einer als gebrauchsfähig anzusehenden Speicherbatterie zu keiner Zeit t, während die Speicherbatterie mit dem Belastungsprofil beaufschlagt wird, von der Spannung U(t) unterschritten {überschritten} werden darf,
d) der Speicherbatterie der Gebrauchstüchtigkeitswert SOH = "0" zugeordnet, wenn der Spannungsgrenzwert U1 während der Beaufschlagung der Speicherbatterie mit dem Belastungsprofil zu mindestens einem Zeitpunkt t1 erreicht wird, dieser Spannungsgrenzwert U1 aber nicht unterschritten {überschritten} wird,
e) der Speicherbatterie ein Gebrauchstüchtigkeitswert "SOH" zugeordnet, der sich nach der Differenz zwischen dem niedrigsten {höchsten} Spannungswert Umin {Umax} während der Beaufschlagung der Speicherbatterie mit dem Belastungsprofil und dem Spannungsgrenzwert U1 bemisst:

$$SOH = f(Umin - U1)$$

$$\{ SOH = f(Umax - U1) \}$$

Weiterhin wird eine Speicherbatterie ein Gebrauchstüchtigkeitswert SOH = 100% zugeordnet, bei der der niedrigste {höchste} Spannungswert Umin { Umax } während der Beaufschlagung der Speicherbatterie mit dem Belastungsprofil gleich dem Wert Spannungswert Umin* {Umax*} ist, der sich bei Beaufschlagung einer baufrischen, für diese Anwendung typischen und geeigneten (d.h. es gilt Umin* > U1 {Umax* < U1} - ansonsten ist die Batterietype für das betrachtete Belastungsprofil ungeeignet) Speicherbatterie ergibt.

Einer Speicherbatterie wird ein Gebrauchstüchtigkeitswert SOH < 0% zugeordnet, bei der der Spannungsgrenzwert U1 zu mindestens einem Zeitpunkt unterschritten {überschritten} wird, und dieser Wert SOH sich nach der Differenz zwischen dem niedrigsten {höchsten} Spannungswert während der Beaufschlagung der Speicherbatterie mit dem Belastungsprofil und dem Spannungsgrenzwert U1 bemisst:

$$\text{SOH} = f\,(\text{Umin} - \text{U1})$$

$$\{\ \text{SOH} = f\,(\text{Umax} - \text{U1})\ \}$$

Allgemein ergibt sich der einer Speicherbatterie zugeordnete Gebrauchstüchtigkeitswert SOH nach folgender Formel: (Formel 1)

$$\text{SOH} = (\text{Umin} - \text{U1})\,/\,(\text{Umin*} - \text{U1})$$

$$\{\ \text{SOH} = (\text{Umax} - \text{U1})\,/\,(\text{Umax*} - \text{U1})\ \}\ ;$$

wobei (Umin* - U1) { bzw. (Umax* - U1)} ein Sollwert ist, der sich aus dem Verhalten einer für diese Anwendung typischen und geeigneten (d.h. es gilt Umin* > U1 {bzw. Umax* < U1} - ansonsten ist die Batterietype für das betrachtetet Belastungsprofil ungeeignet) Speicherbatterie ergibt.

In einer weiteren Ausführungsform des Verfahrens gemäß der Erfindung wird einer Speicherbatterie ein Gebrauchstüchtigkeitswert SOH zugeordnet, der sich nicht durch Messung des niedrigsten Spannungswerts Umin {des höchsten Spannungswerts Umax} durch tatsächliche elektrische Beaufschlagung der Speicherbatterie mit einem Strombelastungsprofil I(t) oder einem Leistungsprofil P(t) nach Anspruch 1 a), sondern durch Berechnung des niedrigsten Spannungswerts Umin {des höchsten Spannungswerts Umax} aus zuvor berechneten oder geschätzten Werten einer oder mehrerer der Größen Ruhespannung der Batterie Uo, Ladezustand der Batterie SOC, Temperatur der Batterie T, Widerstand der Batterie Ri und Einsetzen dieses Wertes in die im vorigen Absatz genannte Formel 1 ergibt.

Es kann auch einer Speicherbatterie ein Gebrauchstüchtigkeitswert SOH zugeordnet werden, der sich nicht durch Messung des niedrigsten Spannungswerts Umin {des höchsten Spannungswerts Umax} durch tatsächliche elektrische Beaufschlagung der Speicherbatterie mit einem Entlade-Strombelastungsprofil I(t) (mit I<0) nach Anspruch 1 a), sondern durch Berechnung des niedrigsten Spannungswerts Umin durch Einsetzen der Beziehung

$$\text{Umin} = \text{Minimum}\ \{\text{U(t)}\}$$

mit

$$\text{U(t)} = \text{Uo(SOC,T)} + \text{Ri(SOC,T)} \times \text{I(t)}$$

in Formel 1 ergibt.

Dabei steht Ri für den von Ladezustand SOC und Temperatur T der Batterie abhängenden dynamische Innenwiderstand der Speicherbatterie, Uo für die von Ladezustand SOC und Temperatur T der Batterie abhängenden Ruhespannung der Speicherbatterie, und Minimum {U(t)} steht für den kleinsten Spannungswert, der sich durch Einsetzen von I(t) ergibt.

Schließlich kann einer Speicherbatterie ein Gebrauchstüchtigkeitswert SOH zugeordnet werden, der sich nicht durch Messung des niedrigsten Spannungswerts Umin durch tatsächliche elektrische Beaufschlagung der Speicherbatterie mit dem Entlade-Leistungsbelastungsprofil P(t) (mit P<0) ergibt, sondern durch Berechnung durch Einsetzen der Beziehung

$$ Umin = Minimum \ \{U(t)\} $$

mit

$$ U(t) = \frac{Uo(SOC,T)}{2} + \sqrt{\frac{(Uo(SOC,T))^2}{4} - Ri(SOC,T) x P(t)} $$

in Formel 1 ergibt.

Dabei steht Ri für den von Ladezustand SOC und Temperatur T der Batterie abhängenden dynamische Innenwiderstand der Speicherbatterie, Uo für die von Ladezustand SOC und Temperatur T der Batterie abhängenden Ruhespannung der Speicherbatterie, und Minimum {U(t)} steht für den kleinsten Spannungswert, der sich durch Einsetzen von P(t) ergibt.

Es ist auch möglich, einer Speicherbatterie einen Gebrauchstüchtigkeitswert SOH zuzuordnen, der sich auf einen derzeit nicht vorliegenden, hypothetischen Betriebszustand der Speicherbatterie bezieht, der sich vom derzeitigen Betriebszustand zumindest im Ladezustand SOC oder in der Temperatur T unterscheidet, wobei

a) der Innenwiderstand, der Ladezustand, die Ruhespannung und die Temperatur der Speicherbatterie gemessen oder abgeschätzt werden,
b) die so erhaltenen Werte verwendet werden, um die Ruhespannung der Speicherbatterie zu berechnen oder abzuschätzen,
c) eine Korrektur der Ruhespannung Uo und des Innenwiderstands Ri entsprechend der in einem Speicherbaustein abgelegten funktionalen Zusammenhänge Uo(SOC,T) erfolgt,
d) daraus eine Spannungsantwort U(t) auf ein Strombelastungsprofil I(t) oder ein Leistungsbelastungsprofil P(t) berechnet wird;
e) daraus der Gebrauchstüchtigkeitswert SOH der Batterie ermittelt wird.

In einer anderen Ausgestaltung treten anstelle eines Spannungsgrenzwertes U1, der nie unterschritten wird, ein oder mehrere Spannungsgrenzwerte Uli (i = 1,...), die zwar für jeweils eine Zeitdauer von max τi unterschritten werden dürfen, nicht aber für eine Dauer τi. Dann wird nicht nur die Relation von Umin und Uli zur Ermittlung von SOH verwendet, sondern die Zeitdauer τ bewertet, für die gegebenenfalls Umin < Uli liegt. Für τ > τi wird ein Wert SOHi > 0 ermittelt, für τ = τi ein Wert SOHi = 0, und für τ < τi ein Wert SOHi < 0. Es können auch andere Grenzwertpaare (Uli, τi) festgelegt und für diese ein SOHi berechnet werden. Der Speicherbatterie wird dann das Minimum dieser Werte SOHi als SOH zugewiesen.

Mit dem so ermittelten Gebrauchstüchtigkeitswert SOH wird in Anhängigkeit von diesem Wert eine Maßnahme im Zusammenhang mit der mit der Speicherbatterie verbundenen Anlage eingeleitet wird, wie z.B.

- eine Information an den Betreiber der Anlage
- eine Änderung in der Betriebsführung der Anlage
- ein Notbetrieb der Anlage
- eine Außerbetriebnahme der Anlage.

Oder es wird ein Gebrauchstüchtigkeitswert SOH ermittelt und in Anhängigkeit von diesem Wert sowie gegenwärtigen oder in der Zukunft erwarteten, durch Ladezustand SOC und Temperatur T der Batterie gekennzeichneten Betriebszuständen, eine Maßnahme im Zusammenhang mit der mit der Speicherbatterie verbundenen Anlage eingeleitet wird, wie zum Beispiel

- eine Information an den Betreiber der Anlage

- eine Änderung in der Betriebsführung der Anlage
- ein Notbetrieb der Anlage
- eine Außerbetriebnahme der Anlage.

**Patentansprüche**

1. Verfahren zur Bewertung der Gebrauchstüchtigkeit einer Speicherbatterie bei elektrischer Belastung der Speicherbatterie, **dadurch gekennzeichnet, dass** der Speicherbatterie ein Gebrauchstüchtigkeitswert SOH zugeordnet wird, der sich auf einen derzeit nicht vorliegenden, hypothetischen Betriebszustand der Speicherbatterie bezieht, der sich vom derzeitigen Betriebszustand zumindest im Ladezustand SOC oder in der Temperatur T unterscheidet, wobei

   a) der Innenwiderstand, der Ladezustand, die Ruhespannung und die Temperatur der Speicherbatterie gemessen oder abgeschätzt werden,
   b) die so erhaltenen Werte verwendet werden, um die Ruhespannung der Speicherbatterie zu berechnen oder abzuschätzen,
   c) eine Korrektur der Ruhespannung Uo und des Innenwiderstandes Ri entsprechend der in einem Speicherbaustein abgelegten funktionalen Zusammenhänge Uo(SOC,T) und Ri(SOC,T) im Hinblick auf den hypothetischen Betriebszustand (SOC,T) erfolgt,
   d) daraus eine Spannungsantwort U(t) auf ein Strombelastungsprofil I(t) oder ein Leistungsbelastungsprofil P(t) berechnet wird;
   e) daraus der Gebrauchstüchtigkeitswert SOH der Batterie ermittelt wird, wobei
   f) der Speicherbatterie der Gebrauchstüchtigkeitswert SOH zugeordnet wird, der sich nach der Differenz zwischen dem niedrigsten Spannungswert Umin bzw. dem höchsten Spannungswert Umax der Spannungsantwort U(t) und einem Spannungsgrenzwert U1 bemisst, wobei der Spannungsgrenzwert U1 ein Spannungswert ist, der bei einer als gebrauchsfähig anzusehenden Speicherbatterie zu keiner Zeit t der Strombelastung oder der Leistungsbelastung von der Spannungsantwort U(t) im Falle des niedrigsten Spannungswerts Umin unterschritten bzw. im Falle des höchsten Spannungswerts Umax überschritten werden darf.

2. Verfahren nach Anspruch 1, **dadurch gekennzeichnet, dass** der Speicherbatterie der Gebrauchstüchtigkeitswert SOH = 0 % zugeordnet wird, wenn der Spannungsgrenzwert U1 von der Spannungsantwort U(t) zu mindestens einem Zeitpunkt t1 erreicht wird, dieser Spannungsgrenzwert U1 im Falle des niedrigsten Spannungswerts Umin aber nie unterschritten bzw. im Falle des höchsten Spannungswerts Umax aber nie überschritten wird, und einer Speicherbatterie der Gebrauchstüchtigkeitswert SOH = 100% zugeordnet wird, wenn im Falle des niedrigsten Spannungswerts Umin dieser während der Strombelastung oder der Leistungsbelastung gleich dem niedrigsten Spannungswert Umin* bzw. im Falle des höchsten Spannungswerts Umax dieser während der Strombelastung oder der Leistungsbelastung gleich dem höchsten Spannungswert Umax* ist, der sich bei Beaufschlagung einer baufrischen, für diese Anwendung typischen und geeigneten Speicherbatterie ergibt.

3. Verfahren nach Anspruch 1 oder 2, **dadurch gekennzeichnet, dass** einer Speicherbatterie der Gebrauchstüchtigkeitswert SOH < 0% zugeordnet wird, wenn der Spannungsgrenzwert U1 zu mindestens einem Zeitpunkt im Falle des niedrigsten Spannungswerts Umin diesen unterschreitet bzw. im Falle des höchsten Spannungswerts Umax diesen überschreitet, und der Gebrauchstüchtigkeitswert SOH > 100% zugeordnet wird, wenn im Falle des niedrigsten Spannungswerts Umin dieser während der Strombelastung oder der Leistungsbelastung größer als der Spannungswert Umin* bzw. im Falle des höchsten Spannungswerts Umax dieser während der Strombelastung oder der Leistungsbelastung kleiner als der Spannungswert Umax* ist, der sich bei Beaufschlagung einer baufrischen, für diese Anwendung typischen und geeigneten Speicherbatterie ergibt.

4. Verfahren nach Anspruch 1 oder 2, **dadurch gekennzeichnet, dass** einer Speicherbatterie der Gebrauchstüchtigkeitswert SOH zugeordnet wird, der sich nach folgender Formel ergibt:

$$SOH = (Umin - U1) / (Umin^* - U1)$$

bzw.

$$SOH= (Umax - U1) / (Umax^* - U1)$$

wobei (Umin* - U1) bzw. ( Umax* - U1) ein Sollwert ist, der sich aus dem Verhalten einer für diese Anwendung typischen und geeigneten Speicherbatterie ergibt.

**5.** Verfahren nach einem oder mehreren der Ansprüche 1 bis 4, **dadurch gekennzeichnet, dass** einer Speicherbatterie der Gebrauchstüchtigkeitswert SOH zugeordnet wird, der sich durch Berechnung des niedrigsten Spannungswertes Umin bzw. des höchsten Spannungswertes Umax aus zuvor gemessenen, berechneten oder geschätzten Werten eines oder mehreren der Größen Ruhespannung der Batterie Uo, Ladezustand der Batterie SOC, Temperatur der Batterie T, Widerstand der Batterie Ri ergibt.

**6.** Verfahren nach Anspruch 5, **dadurch gekennzeichnet, dass** zur Berechnung des niedrigsten Spannungswerts Umin die Beziehung

$$Umin = Minimum \{ U(t)\}$$

mit

$$U(t) = Uo(SOC,T) + Ri(SOC,T) \times I(t)$$

verwendet wird, wobei als Belastungsprofil ein Stromprofil I(t) verwendet wird.

**7.** Verfahren nach Anspruch 5, **dadurch gekennzeichnet, dass** zur Berechnung des niedrigsten Spannungswerts Umin die Beziehung

$$Umin = Minimum \{ U(t)\}$$

mit

$$U(t) = \frac{Uo(SOC,T)}{2} + \sqrt{\frac{(Uo(SOC,T)^2}{4} - Ri(SOC,T) \times P(t)}$$

verwendet wird, wobei als Belastungsprofil ein Leistungsprofil P(t) verwendet wird.

**Claims**

**1.** A method for measuring fitness for use of a storage battery subject to electric loading comprising:

Assigning the storage battery a fitness for use value SOH which relates to a hypothetical operating state, currently not present, of the storage battery, which differs from the current operating state at least in the state of charge SOC or in the temperature T, wherein

a) the internal resistance, the state of charge, the open-circuit voltage and the temperature of the storage battery are measured or estimated,
b) the values thus obtained are used to calculate or estimate the open-circuit voltage of the storage battery,
c) a correction of the open-circuit voltage Uo and the internal resistance Ri is performed in accordance with the functional relationsips Uo (SOC, T) and Ri (SOC, T) stored in a memory device with regard to the hypothetical operating state (SOC, T),

d) a voltage response U(t) to a current load profile I(t) or a power load profile P(t) is calculated therefrom; and

e) the fitness for use value SOH of the battery is determined therefrom, thereby

f) determining the fitness for use value SOH for the storage battery based on the difference between the lowest voltage value Umin respectively the highest voltage value Umax of the voltage response U(t) and on a voltage limiting value U1, wherein the voltage limiting value U1 is a voltage value which may not be undershot by the voltage response U(t) at any time t of the current load or the power load in case of the lowest voltage value Umin respectively may not be overshot in case of the highest voltage value Umax, assuming a usable storage battery.

2. The method as claimed in claim 1, wherein the storage battery is assigned the fitness for use value SOH = O when the voltage limiting value U1 is reached at at least an instant tl, with the proviso that the voltage limiting value U1 is not undershot in case of the lowest voltage value Umin respectively is not overshot in case of the highest voltage value Umax, and the fitness for use value SOH = 100 % is assigned when in case of the lowest voltage value Umin this value is equal during the current load or the power load to the lowest voltage value Umin* for a new storage battery, which is typical and suitable for the application, respectively when in case of the highest voltage value Umax this value is equal during application of the current load or the power load to the highest voltage value Umax* for the new storage battery.

3. The method as claimed in claim 1 or 2, wherein the storage battery is assigned the fitness for use value SOH < 0 % when the voltage limiting value U1 is undershot at at least one instant in case of the lowest voltage value Umin respectively when the voltage limiting value U1 is overshot at at least one instant in case of the highest voltage value Umax, and is assigned the fitness for use value SOH > 100 % when in case of the lowest voltage value Umin this value is larger during the current load or the power load than the voltage value Cumin* for a new storage battery, which is typical and suitable for the application, respectively when in case of the highest voltage value Umax this value is equal during application of the current load or the power load to the highest voltage value Umax* for the new storage battery.

4. The method as claimed in claim 1 or 2, wherein the storage battery is assigned the fitness for use value SOH which is determined from the following formula:

$$\text{SOH} = (\text{Umin-U1}) / (\text{Umin*-U1})$$

resp.

$$\text{SOH} = (\text{Umax-U1}) / (\text{Umax*-U1}),$$

wherein (Umin*-U1) respectively (Umax*-U1) is a nominal value which results from a storage battery which is typical and suitable for the application.

5. The method as claimed in one or more of claims 1 to 4, wherein the storage battery is assigned the fitness for use value SOH determined from calculating the lowest voltage value Umin respectively the highest voltage value Umax from previously measured, calculated or estimated values of one or more of variables selected from the group consisting of open-circuit voltage of the battery Uo, battery state of charge SOC, temperature of the battery T and resistance of the battery Ri.

6. The method as claimed in claim 5, wherein the relationship

$$\text{Umin} = \text{Minimum } \{U(t)\}$$

where

$$U(t) = \text{Uo (SOC, T)} + \text{Ri (SOC, T) x I(t)}$$

is used to calculate the lowest voltage value Umin, whereby a current load profile I(t) is used as load profile.

**7.** The method as claimed in claim 5, wherein the relationship

$$\text{Umin} = \text{Minimum } \{U(t)\}$$

with

$$U(t) = \frac{Uo(SOC, T)}{2} + \sqrt{\frac{(Uo(SOC, T)^2}{4} - Ri(SOC, T) \times P(t)}$$

is used to calculate the lowest voltage value Umin, whereby a power load profile P(t) is used as load profile.

**Revendications**

**1.** Procédé d'évaluation de l'état de santé d'une batterie de stockage lors de la charge électrique de la batterie de stockage, **caractérisé en ce qu'**on associe à la batterie de stockage une valeur d'état de santé SOH qui se réfère à un état de fonctionnement non encore présent et hypothétique de la batterie de stockage, qui est différent de l'état de fonctionnement courant en ce qui concerne au moins l'état de charge SOC ou la température T, dans lequel

    a) on mesure ou on estime la résistance interne, l'état de charge, la tension en circuit ouvert et la température de la batterie de stockage ;
    b) on utilise les valeurs ainsi obtenues pour calculer ou estimer la tension en circuit ouvert de la batterie de stockage ;
    c) on effectue une correction de la tension en circuit ouvert Uo et de la résistance interne Ri conformément aux relations fonctionnelles Uo(SOC,T) et Ri(SOC,T) stockées dans un module de mémoire et se rapportant à l'état de fonctionnement hypothétique (SOC,T) ;
    d) on calcule à partir de cela une réponse en tension U(t) sur la base d'un profil de charge en courant I(t) ou d'un profil de charge en puissance P(t) ;
    e) on détermine à partir de cela une valeur d'état de santé SOH de la batterie, cela consistant **en ce que** :
    f) on associe à la batterie de stockage la valeur d'état de santé SOH qui est mesurée sur la base de la différence entre la valeur de tension la plus faible Umin ou de la valeur de tension la plus élevée Umax de la réponse en tension U(t) et une valeur de tension de seuil U1, la valeur de tension de seuil U1 étant une valeur de tension qui, pour qu'une batterie de stockage soit considérée comme utilisable, ne doit à aucun instant t de la charge en courant ou de la charge en puissance, être supérieure à la réponse en tension U(t), dans le cas de la valeur de tension la plus faible Umin, ou être inférieure à celle-ci, dans le cas de la valeur de tension la plus élevée Umax.

**2.** Procédé selon la revendication 1, **caractérisé en ce qu'**on associe à la batterie de stockage la valeur d'état de santé SOH = 0 % lorsque la valeur de seuil de tension U1 est atteinte par la réponse en tension U(t) en au moins un point dans le temps t1, cette valeur de seuil de tension U1 n'étant cependant jamais dépassée en sens décroissant dans le cas de la valeur de tension la plus faible Umin et n'étant jamais dépassée en sens croissant dans le cas de la valeur de tension la plus élevée Umax, et **en ce qu'**on associe à la batterie de stockage une valeur d'état de santé SOH = 100 % lorsque, pendant la charge en courant ou la charge en puissance, dans le cas de la valeur de tension la plus faible Umin, celle-ci est égale à la valeur de tension la plus faible Umin* ou lorsque, pendant la charge en courant ou la charge en puissance, dans le cas de la valeur de tension la plus élevée Umax, celle-ci est égale à la valeur de tension la plus élevée Umax*, cette valeur étant obtenue lors de la mise en oeuvre d'une batterie de stockage neuve, typique de, et appropriée pour cette application.

**3.** Procédé selon la revendication 1 ou 2, **caractérisé en ce qu'**on associe à une batterie de stockage une valeur d'état de santé SOH < 0 % lorsque, en au moins un point dans le temps, la valeur de seuil de tension U1 devient inférieure à la valeur de tension la plus faible Umin ou devient supérieure à la valeur de tension la plus élevée Umax, et **en ce qu'**on lui associe la valeur d'état de santé SOH > 100 % lorsque, dans le cas de la valeur de tension la plus faible Umin, celle-ci est supérieure à la valeur de tension Umin* pendant la charge en courant ou la charge en puissance ou lorsque, dans le cas de la valeur de tension la plus élevée Umax, celle-ci est inférieure à la valeur de tension Umax* pendant la charge en courant ou la charge en puissance, cette valeur étant obtenue lors de la mise en oeuvre d'une batterie de stockage neuve, typique de, et adaptée à cette application.

4. Procédé selon la revendication 1 ou 2, **caractérisé en ce qu'**on associe à une batterie de stockage une valeur d'état de santé SOH qui est obtenue conformément à la formule suivante :

$$SOH = (Umin-U1)/(Umin*-U1)$$

ou

$$SOH = (Umax-U1)/(Umax*-U1)$$

où (Umin*-U1) ou (Umax*-U1) est une valeur nominale qui est obtenue à partir du comportement d'une batterie de stockage typique de, et adaptée à cette application.

5. Procédé selon l'une des revendications 1 à 4, **caractérisé en ce qu'**on associe à une batterie de stockage la valeur d'état de santé SOH qui est obtenue par calcul de la valeur de tension la plus faible Umin ou de la valeur de tension la plus élevée Umax à partir de valeurs précédemment mesurées, calculées ou estimées d'une ou plusieurs grandeurs, à savoir la tension en circuit ouvert Uo de la batterie, l'état de charge SOC de la batterie, la température T de la batterie, et la résistance Ri de la batterie.

6. Procédé selon la revendication 5, **caractérisé en ce que**, pour calculer la valeur de tension la plus faible Umin, on utilise la relation suivante :

$$Umin = minimum\{U(t)\},$$

avec

$$U(t) = Uo(SOC,T) +$$

$$Ri(SOC,T) \times I(t),$$

un profil de courant I(t) étant utilisé en tant que profil de charge.

7. Procédé selon la revendication 5, **caractérisé en ce que**, pour calculer la valeur de tension la plus faible Umin, on utilise la relation suivante :

$$Umin = minimum\{U(t)\},$$

avec

$$U(t) = \frac{Uo(SOC,T)}{2} + \sqrt{\frac{Uo(SOC,T)^2}{4} - Ri(SOC,T) \times P(t)} \, ,$$

un profil de puissance P(t) étant utilisé en tant que profil de charge.

Fig. 1

Umin>Umin*:   SOH > 100%

Umin=Umin*:   SOH = 100%

Umin:        0 < SOH < 100%

Umin=U1:      SOH = 0%

Umin<U1 :   SOH < 0%

EP 1 116 958 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE PS2242510 C
- DE OS4007883 A
- DE OS19543874 A
- JP 11014719 A
- EP 0004382 A1
- DE PS3901680 C
- DE OS4339568 A